(19) Europäisches Patentamt
European Patent Office
Office européen des brevets

(11) EP 1 553 447 A1

(12) **EUROPEAN PATENT APPLICATION**
published in accordance with Art. 158(3) EPC

(43) Date of publication:
**13.07.2005 Bulletin 2005/28**

(21) Application number: **03741257.4**

(22) Date of filing: **08.07.2003**

(51) Int Cl.7: **G03F 7/004**, G03H 1/02, C08G 65/18

(86) International application number:
**PCT/JP2003/008634**

(87) International publication number:
**WO 2004/017141 (26.02.2004 Gazette 2004/09)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **14.08.2002 JP 2002236486**
**30.05.2003 JP 2003154206**

(71) Applicant: **Konica Medical and Graphic Corporation**
**Tokyo 163-0512 (JP)**

(72) Inventors:
- **Sasa, Nobumasa,**
**Konica Medical And Graphic Corp.**
**Hino-shi, Tokyo 191-8511 (JP)**
- **Takeyama, Toshihisa,**
**Hino-shi, Tokyo 191-8511 (JP)**

(74) Representative: **Murphy, Colm Damien et al**
**Urquhart-Dykes & Lord LLP,**
**30 Welbeck Street**
**London W1G 8ER (GB)**

(54) **OPTICAL IMAGE RECORDING MATERIAL, HOLOGRAM BASE BODY, METHOD OF OPTICAL IMAGE RECORDING AND PROCESS FOR PRODUCING OPTICAL IMAGE RECORDING MATERIAL AND HOLOGRAM BASE BODY**

(57) An optical image recording material containing an oxetane compound having 1 - 4 oxetane rings, a cationic photopolymerization initiator, and a matrix forming precursor substance.

FIG. 1

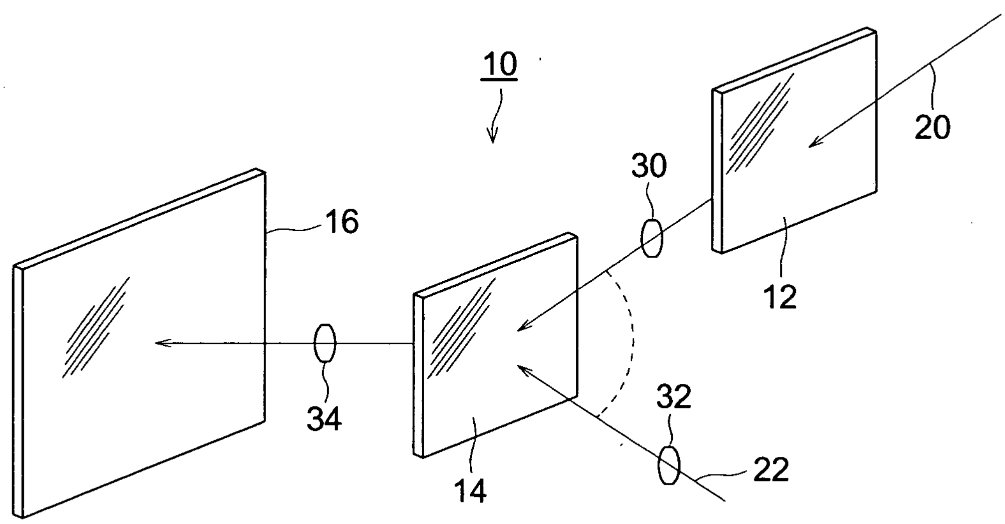




Printed by Jouve, 75001 PARIS (FR)

## Description

TECHNICAL FIELD OF THE INVENTION

The present invention relates to an optical image recording material containing an oxetane compound having an oxetane ring, a hologram material provided hologram record onto the optical image recording material, an optical image recording method using the optical image recording material, and a production method of the optical image recording material and the hologram material. Specifically a holography recording medium is listed as the optical image recording material.

## BACKGROUND OF THE INVENTION

In recent years, developers of information storage devices and related methods have continued to pursue increased data storage capacity. As part of this development, a page method of a memory system, especially a holography system, has been proposed to replace conventional memory devices. A page method system is related with the memory and read-out of data on entire two-dimensional page. Specifically, recording light passes through a two-dimensional array of dark and transparent regions showing a page of data, and the holography system memorizes a holography expression of the page in three dimensions as changing patterns of refraction index and/or absorption which are imprinted in the storage medium.

A general holography system is described in Holography Memory, by D. Psaltis, et al., Scientific American, Nov. 1995. One means of the holography memory is phase correlation multiplex holography, which is described in U. S. Patent No. 5,719,691. In phase correlation multiplex holography, the reference beam passes through a phase mask, after which it intersects in the recording medium with a signal beam passed through the data array, and then a hologram is formed in the medium. By controlling the relationship of the phase mask and the reference beam in each of subsequent data pages, it enables modulation of the phase of the reference beam and also allows memorizing data in a duplicate region of the medium. Afterward, the data is rebuilt by passage of the reference beam through the former storage position at the same phase modulation as used during data storage.

The function of a holography storage system is dependent on the storage medium. As a storage medium of a research object, lithium niobate doped with iron particles has been employed. However, lithium niobate is costly, yet its sensitivity is low, and it exhibits a tendency to generate noise during read-out of the memorized information.

Therefore, alternatives have been sought, specifically in the field of photosensitive polymer film. For example, those are described in Photopolymer for Holography, by W. K. Smothers, et al., SPIE OE/Laser Conference, 1212-03, Los Angels, California, 1990. Described in the same is a material which contains an optical image forming system of a liquid monomer material and a photopolymerization initiator (being used to accelerate polymerization of the monomer when exposed to light) in a matrix organic polymer being basically inactive to light exposure. While writing the information into the material, a monomer is polymerized in an exposure region by passing the recording light through the data array. As a result, since concentration of the monomer is reduced, monomer in dark and unexposed regions of the material defuses to the exposed region. The concentration gradient generated by polymerization, and the result of it, leads to changes of the refraction index, and formation of a hologram containing data. However, since adhesion of the pre-forming matrix material containing an optical image forming system requires use of a solvent, the thickness of the material is only restricted, for example, to about 150 μm, to enable adequate vaporization of the solvent. Further, 4 - 10% of material shrinkage, caused by polymerization, exhibits a degrading influence on reliability of data retrieval.

Therefore, this proposal for a polymer holography medium is made. These holography media are described in Unexamined Japanese Patent Application Publication (hereinafter, referred to as JP-A) 11-352303 (corresponding to U.S. Patent No. 6,482,551). These polymer holography media are formed by mixing a monomer or oligomer matrix precursor substance and a photoactive monomer, after which the mixture is cured, and employed for holography recording by (a) forming the matrix with a monomer or oligomer matrix precursor substance, and further (b) retaining a portion of the photoactive monomer in to remain situ, and not reacted. In the case of adhesion of these materials, since a solvent is not needed (because the mixture is liquid), it can be easily thickened, for example, to be more than 1 mm.

The attempt to provide an optical image forming system containing a monomer in a glass matrix is also proposed. For example, proposed is an optical image forming system which contains a glassy hybrid inorganic/organic three dimensional matrix, which also contains more than one photoactive organic monomers. This kind of optical image forming system is described, for example, in JP-A 11-344917 (corresponding to U.S. Patent No. 6,268,089). The medium is produced as follows: employing a hybrid inorganic/organic matrix precursor substance, which is mixed with the optical image forming system, curing the matrix precursor substance, and forming the matrix at the former location. The glass matrix, in contrast with the medium containing a polymer matrix, can provide the desired structural integrity, and enables formation of a relatively thicker optical image recording material (for example, exceeding 1 mm) useful as a holography storage system.

All of the above optical image recording materials are radical polymerization materials, but specifically, have the drawback of shrinkage accompanying polymerization. Therefore, for example, a method employing an optical image recording material of a cationic polymerization is proposed. This method is described in Japanese Translation of PCT International Application Publication No. 2001-523842 (corresponding to PCT International Application Publication No. WO 99/26112). However, with this method, there is the problem of losing the benefit which is exhibited by a radical polymerization, such as requiring lower recording energy for optical recording.

Thus, development of optical image recording materials suitable for a holography storage system in recent years has made notable progress, but still further progress is needed. Specifically, desired is a media which are superior in chemical and structural nature, and are able to form a relatively thick layer (for example, more than 1 mm) without complicated chemical treatments, and enable recording at relatively low optical recording energy, and further, exhibit no problems such as material shrinkage accompanying optical recording.

## SUMMARY OF THE INVENTION

The present invention was achieved in view of the above-mentioned problems. An object of the present invention is to provide an optical image recording material which exhibits superiority in sensitivity speed, shrinking resistance, and contrast, a hologram material obtained from the optical image recording material, an optical image recording method, and a production method of the optical image recording material and the hologram material.

The foregoing object of the present invention can be accomplished by the following embodiments.

Item 1. An optical image recording material comprising a support having thereon a layer containing an oxetane compound containing 1 - 4 oxetane rings in the molecule, a cationic photopolymerization initiator and a matrix forming precursor substance.

Item 2. The optical image recording material of Item 1, further comprising a compound containing an epoxy group in the molecule.

Item 3. The optical image recording material of Item 1, further comprising a compound containing a vinyl ether group in the molecule.

Item 4. The optical image recording material of Item 1, further comprising:

(i) a compound containing an acryloyl group or
(ii) a metacryloyl group in the molecule; and
(iii) a photo radical polymerization initiator.

Item 5. The optical image recording material of Item 1, wherein the matrix forming precursor substance is capable of forming a binder-matrix with at least one polymerization reaction selected from the group consisting of epoxy - amine step polymerization, epoxy - mercaptan step polymerization, unsaturated ester - amine step polymerization, unsaturated ester - mercaptan step polymerization, vinyl-silicone hydride step polymerization, isocyanate - hydroxyl step polymerization, and isocyanate - amine step polymerization.

Item 6. The optical image recording material of Item 1, wherein the matrix forming precursor substance is represented by Formula (I):

Formula (I)

$$R_nM(OR')_{4-n}$$

wherein M is a metallic atom having an atomic valence of not less than trivalent, R is an alkyl or allyl group, R' is a lower alkyl group having no more than four carbon atoms, and "n" is 1 or 2.

Item 7. The optical image recording material of Item 6, wherein M in Formula (I) is a metallic atom selected from the group consisting of silicon, titanium, germanium, zirconium, vanadium, and aluminum.

Item 8. An optical image recording material comprising a first substrate, a second substrate, and an optical image recording layer between the first and the second substrate,

wherein the optical image recording layer contains an oxetane compound having 1 - 4 oxetane rings in the molecule, a cationic photopolymerization initiator, and a matrix forming precursor substance.

Item 9. The optical image recording material of Item 8, wherein a thickness of the first substrate ($D_1$) and the second substrate ($D_2$) satisfies the following relationship:

$$0.5 \leq D_1/D_2 \leq 2.0$$

Item 10. The optical image recording material of Item 8 containing a binder material obtained by curing a portion of the matrix forming precursor substance.
Item 11. A hologram material obtained by applying holography recording irradiated with active rays onto the optical image recording material of Item 10.
Item 12. An optical image recording material comprising a first substrate, a second substrate, and an optical image recording layer between the first and the second substrate,

wherein the optical image recording layer contains an oxetane compound having 1 - 4 oxetane rings in the molecule, a cationic photopolymerization initiator, and a binder-matrix.

Item 13. A hologram material comprising a first substrate, a second substrate, and an optical image recording layer between the first and the second substrate,

wherein the hologram material contains:

(i) a binder-matrix; and
(ii) a polymer obtained by irradiating with active rays to an oxetane compound having 1 - 4 oxetane rings in the molecule.

Item 14. An optical image recording method using the optical image recording material described in Item 8 comprising the steps of:

a) forming a binder-matrix by curing a portion of the matrix forming precursor substance; and
b) conducting hologram recording by irradiating with active rays onto the optical image recording material.

Item 15. The production method of the optical image recording material described in Item 12, comprising the steps of:

a) mixing an oxetane compound containing 1 - 4 oxetane rings in the molecule, a matrix forming precursor substance, and a cationic photopolymerization initiator; and
b) forming a binder-matrix by curing a portion of matrix forming precursor substance.

Item 16. The production method of the hologram material described in Item 13, comprising the steps of:

a) mixing an oxetane compound containing 1 - 4 oxetane rings in the molecule, a matrix forming precursor substance, and a cationic photpolymerization initiator;
b) forming a binder-matrix by curing a portion of the matrix forming precursor substance; and
c) conducting hologram recording by irradiating active rays onto the optical image recording material.

## BRIEF DESCRIPTION OF THE DRAWINGS

Fig. 1 is a schematic diagram showing a basic configuration of a holographic system employable in this invention.
Fig. 2 is a schematic diagram showing a principle of a measuring equipment used for measurement of the shrinkage ratio.

## DETAILED DESCRIPTION OF THE INVENTION

The present invention will now be detailed below.
In the present invention, one of the characteristics is that the optical image recording material contains an oxetane compound having 1 - 4 oxetane rings in the molecule, a cationic photopolymerization initiator, and a matrix forming precursor substance.
Initially, the oxetane compound having 1 - 4 oxetane rings in the molecule is described. The oxetane compound of this invention is a compound which has an oxetane ring. For example, listed are all of the oxetane compounds heretofore known, which are listed in JP-A Nos. 2001-220526 and 2001-310937.
The oxetane compound of this invention is characterized by having 1 - 4 oxetane rings in the molecule. In cases when a compound having 5 or more oxetane rings is employed, the viscosity of the ink composition is raised high, resulting in handling difficulty, and further the glass-transition temperature of the ink composition is raised high, resulting in insufficient adhesion property of the obtained hardened material.
Specific examples of compounds having oxetane ring(s) of this invention will now be described, but the present

invention is not limited to these examples.

Examples of the compounds having one oxetane ring include compound represented by (1) described below.

Formula (1)

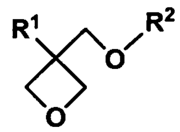

In Formula (1), $R^1$ is a hydrogen atom; an alkyl group having 1 - 6 carbon atoms such as a methyl group, an ethyl group, a propyl group or a butyl group; a fluoroalkyl group having 1 - 6 carbon atoms; an allyl group; an aryl group, a furyl group, or a thienyl group. $R^2$ is an alkyl group having 1 - 6 carbon atoms such as a methyl group, an ethyl group, a propyl group, or a butyl group; an alkenyl group having 2 - 6 carbon atoms such as a 1-propenyl group, a 2-propenyl group, a 2-methyl-1-propenyl group, a 2-methyl-2-propenyl group, a 1-butenyl group, a 2-butenyl group, or a 3-butenyl group; a group having an aromatic ring such as a phenyl group, a benzyl group, a fluorobenzyl group, a methoxybenzyl group, or a phenoxyethyl group; an alkylcarbonyl group having 2 - 6 carbon atoms such as an ethylcarbonyl group, a propylcarbonyl group, or a butylcarbonyl group; an alkoxycarbonyl group having 2 - 6 carbon atoms such as an ethoxycarbonyl group, a propoxycarbonyl group, or a butoxycarbonyl group; or an N-alkylcarbamoyl group having 2 - 6 carbon atoms such as an ethylcarbamoyl group, a propylcarbamoyl group, a butylcarbamoyl group, or a pentylcarbamoyl group. Specifically preferably employed as oxetane compounds used in the present invention are compounds having one oxetane ring, because the resulting composition exhibits excellent adhesion property and also excellent workability due to its low viscosity.

Listed as examples of compounds having two oxetane rings are those represented by Formula (2) described below.

Formula (2)

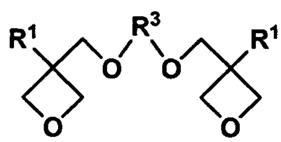

In Formula (2), $R^1$ is of the same group as those in foregoing Formula (1), while $R^2$ is, for example, a straight or branched alkylene group such as an ethylene group, a propylene group, or a butylene group; a straight or branched poly(alkyleneoxy) group such as a poly(ethyleneoxy) group or a poly(propyleneoxy) group; a straight or branched unsaturated hydrocarbon group such as a propenylene group, a methylpropenylene group, or a butenylene group; or a carbonyl group or an alkylene group containing a carbonyl group; an alkylene group containing a carboxyl group; or an alkylene group containing a carbamoyl group.

Further, $R^3$ is a multivalent group selected from the groups represented by Formulas (3), (4), and (5) described below.

Formula (3)

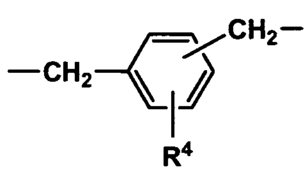

In Formula (3), $R^4$ is a hydrogen atom or an alkyl group having 1 - 4 carbon atoms such as a methyl group, an ethyl group, a propyl group, or a butyl group; an alkoxy group having 1 - 4 carbon atoms such as a methoxy group,

an ethoxy group, a propoxy group, or a butoxy group; a halogen atom such as a chlorine atom or a bromine atom; a nitro group; a cyano group; a mercapto group; a lower alkylcarboxyl group; or a carbamoyl group.

Formula (4)

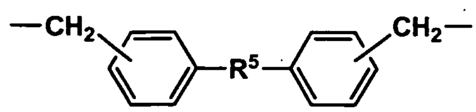

In Formula (4), $R^5$ is an oxygen atom, a sulfur atom, a methylene group, NH, SO, $SO_2$, $C(CF_3)_2$, or $C(CH_3)_2$.

Formula (5)

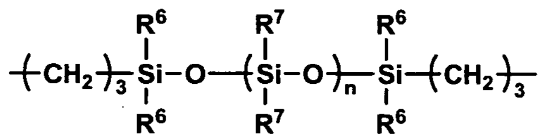

In Formula (5), $R^6$ is an alkyl group having 1 - 4 carbon atoms such as a methyl group, an ethyl group, a propyl group, or a butyl group; or an aryl group. "n" is an integer of 0 - 2,000. $R^7$ is an alkyl group having 1 - 4 carbon atoms such as a methyl group, an ethyl group, a propyl group, or a butyl group; or an aryl group. $R^7$ may also be a group selected from the groups represented by Formula (6) described below.

Formula (6)

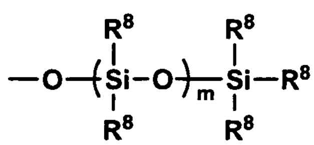

In Formula (6), $R^8$ is an alkyl group having 1 - 4 carbon atoms such as a methyl group, an ethyl group, a propyl group, or a butyl group; or an aryl group. "m" is an integer of 0 - 100.

Listed as specific examples of compounds having two oxetane rings are the compounds described below.

Exemplified Compound 1

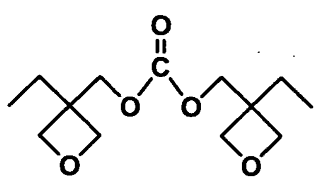

Exemplified Compound 2

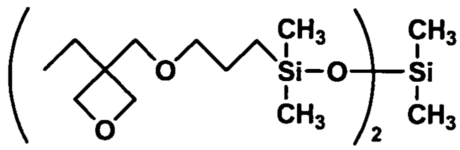

Exemplified Compound 1 is the compound in which in foregoing Formula (2), $R^1$ is an ethyl group, while $R^3$ is a carboxyl group. Further, Exemplified Compound 2 is the compound in which in foregoing Formula (2), $R^1$ is an ethyl group, and $R^3$ is the group of foregoing Formula (5), in which $R^6$ and $R^7$ are each a methyl group, and "n" is 1.

Of compounds having two oxetane rings, examples of preferred compounds, other than those described above, include compounds represented by Formula (7) described below. In Formula (7), $R^1$ is as defined in foregoing Formula (1) for $R^1$.

Formula (7)

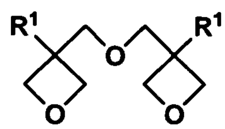

Further, listed as examples of compounds having 3 - 4 oxetane rings are the compounds represented by Formula (8) described below.

Formula (8)

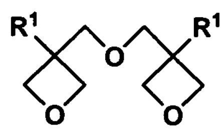

In Formula (8), $R^1$ is as defined in foregoing Formula (I) for $R^1$, $R^9$ is, for example, a branched alkylene group having 1 - 12 carbon atoms such as the groups represented by A - C described below; a branched poly(alkyleneoxy) group such as the groups represented by chemical formula D described below; or is a branched polysiloxy group such as the groups represented by E described below, and "j" is 3 or 4.

A

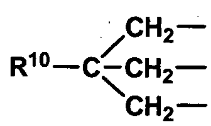

**B**

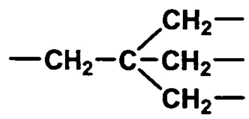

**C**

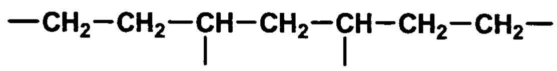

**D**

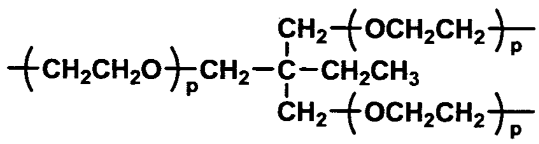

**E**

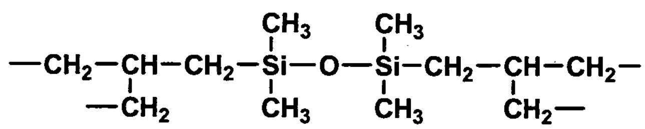

In foregoing "A", $R^{10}$ is a lower alkyl group such as a methyl group, an ethyl group, or a propyl group. Further, in foregoing D, "p" is an integer of 1 - 10.

Listed as one example of a compound having 3 - 4 oxetane rings is Exemplified Compound 3.

Exemplified Compound 3

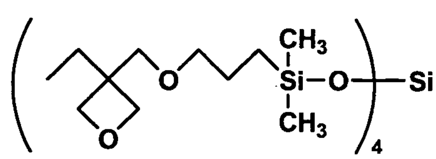

Further, listed as examples of compounds having 1 - 4 oxetane rings in the molecule are compounds represented by Formula (9) described below.

Formula (9)

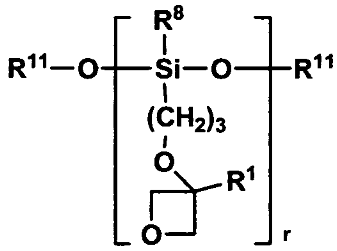

In Formula (9), $R^8$ is as defined in foregoing Formula (6) for $R^8$, $R^{11}$ is an alkyl group having 1 - 4 carbon atoms such as a methyl group, an ethyl group, a propyl group, or a butyl group; or a trialkylsilyl group; and "r" is 1 - 4.

Specific examples of oxetane compounds preferably employed in the present invention include the compounds described below.

Exemplified Compound 4

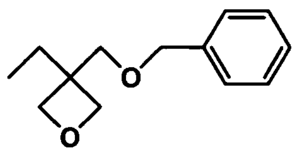

Exemplified Compound 5

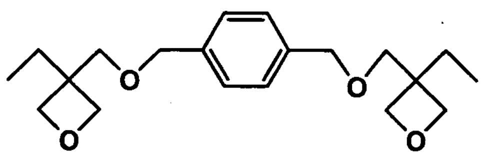

Exemplified Compound 6

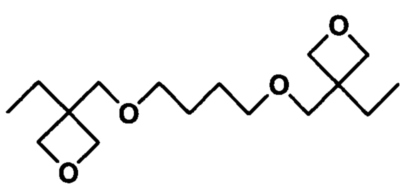

Exemplified Compound 7

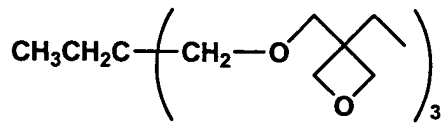

The production methods of each compound having oxetane ring(s) described above are not particularly limited and any conventionally known methods may be employed. For example, known is an oxetane ring synthesis method, which employs diols as a raw material, which is disclosed in D. B. Pattison, J. Am. Chem. Soc., 3455, 79 (1957)). Further, other than these, listed are compounds, having 1 - 4 oxetane rings in the molecule, which have a molecular weight as high as 1,000 - 5,000. Listed as specific examples of these compounds are the compounds described below.

Chemical Formula

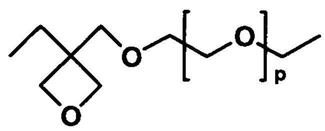

p: 20 - 200

Chemical Formula

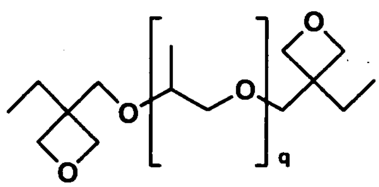

q: 15 - 100

Chemical Formula

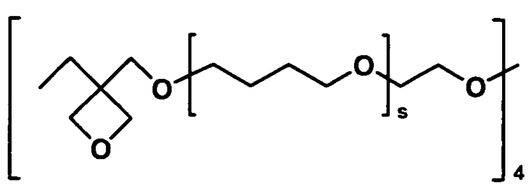

s: 20 - 200

Subsequently, described is a cationic photopolymerization initiator.

As a cationic photopolymerization initiator employed in the optical image recording material of this invention, various compounds, such as a chemical amplification photoresist or a compound used for cationic photopolymerization, may be employed [please refer to Imagingyo Yuki Zairyo (Organic Materials for Imaging), edited by The Japanese Research Association for Organic Electronics Materials, published by Bun-Shin Shuppan (1993), pp. 187 - 192].

Compounds suitable for use in this invention include a diaryl iodonium salt and a triaryl sulfonium salt, while typical cationic photopolymerization initiators are shown in following Formulas (II) - (V).

Formula (II)

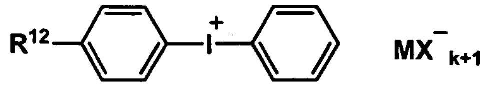

Formula (III)

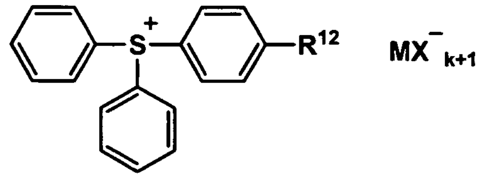

Formula (IV)

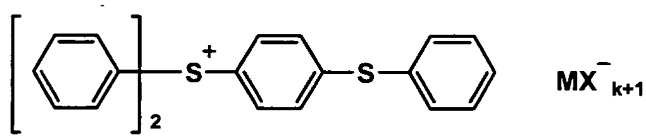

Formula (V)

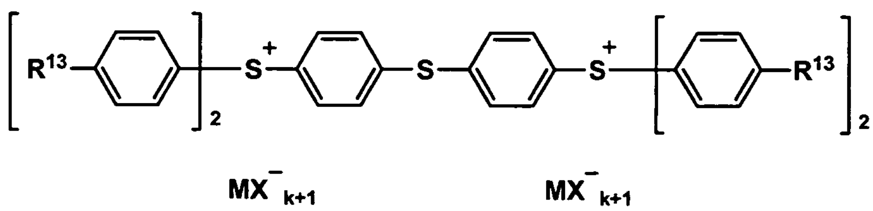

In foregoing Formulas (II) - (V), $R^{12}$ is a hydrogen atom, an alkyl group of 1 -18 carbon atoms, or an alkoxy group of 1 - 18 carbon atoms; $R^{13}$ is a hydrogen atom, a hydroxyalkyl group, or a hydroxyalkoxy group, but is preferably a hydroxyethoxy group. M is a metallic atom, and is preferably antimony; X is a halogen atom, and is preferably fluorine; "k" is valence, and in the case of antimony, "k" is 5. The foregoing cationic photopolymerization initiator is preferably contained in the oxetane compound at a ratio of 0.1 - 20 weight%, but more preferably 0.1 - 10 weight%.

Further, when a compound incorporating an epoxy group or a vinyl ether group, which are described later, is contained in the oxetane compound, the cationic photopolymerization initiator is preferably contained at a ratio of 0.1 - 20 weight% to the total weight of the oxetane compound, and the compound having an epoxy group or a vinyl ether group, is more preferably 0.1 - 10 weight%. The oxetane compound of a photoactive substance is preferably contained at a ratio of 1 - 100% of the above mixture, more preferably 5 - 95%, but most preferably 15 - 90%. In cases when the cationic polymerization initiator is less than 0.1 weight%, curability is insufficient, while when it exceeds 20 weight%, optical transparency is degraded, resulting in uneven curing or roughness of the coated surface.

In the present invention, the foregoing optical image recording material preferably contains a compound incorporating an epoxy group. By such incorporation in the composition of this invention, curing rate of the composition is further improved.

As a compound incorporating an epoxy group, various compounds may be employed. The preferable aromatic epoxide is a polyhydric phenol having at least one aromatic nucleus, or di- or poly-glycidyl ether produced by reaction of an alkylene oxide adduct of a polyhydric phenol and epichlorohydrin, such as, di- or poly-pglycidyl ether of bisphenol

A or its alkylene oxide adduct, di- or poly-pglycidyl ether of hydrogenated bisphenol A or its alkylene oxide adduct, and a novolac epoxy resin. At this point, alkylene oxides include ethylene oxide and propylene oxide.

As an alicyclic epoxide, preferred is a compound containing cyclohexene oxide or cyclopentene oxide, whereby a compound is obtained by epoxidation with an appropriate oxidizing agent such as hydrogen peroxide or a peracid, of a compound having at least one cycloalkane ring such as a cyclohexene or a cyclopentene ring.

Preferable aliphatic epoxides include aliphatic polyhydric alcohol, or di- or poly-glycidyl ether of its alkylene oxide adduct, and the typical examples include, di-glycidyl ether of alkylene glycol, such as di-glycidyl ether of ethylene glycol, di-glycidyl ether of propylene glycol, or di-glycidyl ether of 1,6-hexane diol; poly-glycidyl ether of polyhydric alcohol, such as di- or poly-glycidyl ether of glycerin or its alkylene oxide adduct; poly-glycidyl ether of polyalkylene glycol, such as di-glycidyl ether of polyethylene glycol or its alkylene oxide adduct, or di-glycidyl ether of polypropylene glycol or its alkylene oxide adduct. At this point, as alkylene oxides, listed are ethylene oxide and propylene oxide.

Specifically, in this invention, it is preferred to employ an alicyclic epoxy compound, example of which are the following compounds described below.

E-1

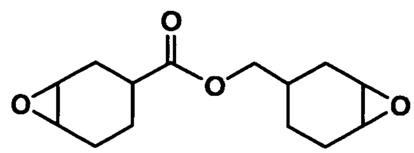

E-2

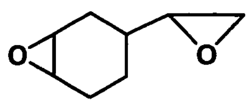

E-3

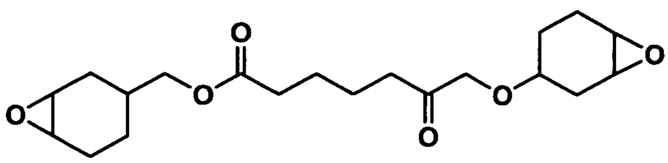

In this case, the mixing ratio of the compound having an epoxy group is preferably 5 - 95 weight parts to the total amount of 100 weight parts of the foregoing compound having 1 - 4 oxetane rings, and compounds having an epoxy group.

In the present invention, it is preferred that the foregoing optical image recording material contains a compounds having a vinyl ether group, whereby the curing rate of the composition is further improved, due to incorporation of the compounds featuring a vinyl ether group, into the composition.

As a compound having a vinyl ether group, various compounds may be employed, for example, compounds having one vinyl ether group include hydroxyethyl vinyl ether, hydroxybutyl vinyl ether, dodecyl vinyl ether, propenyl ether, propylene carbonate, and cyclohexyl vinyl ether. Compounds having two or more vinyl ether groups include cyclohexanedimethanol divinyl ether, triethylene glycol divinyl ether, and novolac type divinyl ether.

In this case, the mixing ratio of a compound having a vinyl ether group is preferably 5 - 95 weight parts to a total amount of 100 weight parts of the foregoing compound having 1 - 4 oxetane rings and the compound having a vinyl ether group.

In this invention, it is preferred that the foregoing optical image recording material contains a compound incorporating a (metha)cryloyl group and a radical photopolymerization initiator. "(metha)cryloyl group" of this invention

indicates an acryloyl group or a methacryloyl group.

In the present invention, due to incorporating a compound incorporating a (metha)cryloyl group in the composition, it is possible to control viscosity of the composition, to enhance coated layer hardness, and to control contrast of the refraction index.

Various compounds having a (metha)cryloyl group may be employed, for example, the compounds having one (metha)cryloyl group include (metha)crylates of phenol, nonylphenol or 2-ethylhexanol, and (metha)crylates of alkylene oxide adducts of these alcohols. Compounds having two (matha)cryloyl groups include di(metha)crylates of bisphenol A, isocyanuric acid, ethylene glycol, and propylene glycol, and di(metha)crylates of alkylene oxide adducts of these alcohols. The compounds having three (metha)cryloyl groups include tri(metha)crylates of pentaerithritol, trimethylolpropane, and isocyanuric acid, as well as tri(metha)crylates of alkylene oxide adducts of these alcohols. Compounds having four or more (metha)cryloyl groups include poly(metha)crylates of pentaerithritol, and dipentaerithritol. Further, listed are well-known acrylic monomers/oligomers such as urethane acrylate having a urethane bond main chain, a polyester acrylate having an ester bond main chain, and an epoxy (metha)crylate of the addition of acrylic acid to an epoxy compound. In this case, the mixing ratio of the compound having a (metha)cryloyl group is preferably 5 - 95 weight parts to the total amount of 100 weight parts of the foregoing compound incorporating 1 - 4 oxetane rings, and the compound having a (metha)cryloyl group.

In the present invention, it is preferable that a radical photopolymerization initiator is incorporated into the composition. As a radical photopolymerization initiator, various compounds can be employed, and listed preferred ones are benzophenone and its derivatives, benzoin alkyl ether, 2-methyl[4-(methylthio)phenyl]-2-morpholino-1-propanone, benzyldimethylketal, 1-hydroxycyclohexyl phenyl ketone, 2-hydroxy-2-methyl-1-phenylpropane-1-one, alkylphenyl glyoxylate, diethoxy acetophenone, 2-benzyl-2-dimethylamino-1-(4-morpholinophenyl)-1-butanone, and acylphosphine oxide. The content of these radical photopolymerization initiators is preferably 0.01 - 20 weight% to the compound having a (metha)cryloyl group.

Further, in this invention, two or more compounds which are selected from the group of the foregoing compound containing an epoxy group, the compound containing a vinyl ether group, and [the compound containing a (metha)cryloyl group and a radical photopolymerization initiator], may be incorporated in the foregoing optical image recording material. In this case, the mixing ratio of the total amount of the compound containing an epoxy group, the compound containing a vinyl ether group and the compound containing a (metha)cryloyl group, is preferably 5 - 95 weight parts to the total amount of 100 weight parts of the compound incorporating 1 - 4 oxetane rings, the compound containing an epoxy group, the compound containing a vinyl ether group, and the compound containing a (metha) cryloyl group.

In the composition of this invention, incorporated may be inert components other than the foregoing components, such as an inorganic filler material, a dye, a viscosity controlling agent, a processing agent, an organic solvent, and an ultraviolet blocking agent, in an amount of up to 100 weight parts to 100 weight parts of the curable components.

Listed as examples of the inorganic filler materials are, for example, metal or nonmetal oxides such as zinc oxide, aluminum oxide, antimony oxide, calcium oxide, chromic oxide, tin oxide, titanium oxide, iron oxide, copper oxide, lead oxide, bismuth oxide, magnesium oxide, and manganese oxide; hydroxides such as aluminum hydroxide, and ferrous hydroxide; salts such as calcium carbonate, and calcium sulfate; silicon compounds such as silicon dioxide; natural pigments such as kaolin, bentonite, clay, and talc; minerals such as natural zeolite, Oyaishi stone, natural mica, and iolite; synthetic inorganic materials such as synthetic mica, and synthetic zeolite; and various metals such as aluminum, iron and zinc.

To the composition of this invention, in addition to the cationic photopolymerization initiator or the radical photopolymerization initiator, a photosensitizing agent may be added to adjust to the wavelength of the light source used for recording. As a usable typical photosensitizing agent in this invention, well-known agents may be employed, but specifically employed are pyrene, perylene, acridine orange, thioxanthone, 2-chlorothiozanthone, benzoflavin, eosin, rose bengal, erythrosine, and methylene blue.

In this invention, binder-matrix formation is conducted by curing the matrix forming precursor substance (also called a binder-matrix forming precursor substance). This matrix forming precursor substance is employed by selecting appropriate organic and/or inorganic compounds, as long as it is capable of binder-matrix formation.

Of these, for binder-matrix formation by use of the precursor substance of an organic material, in other words, as a polymerization reaction to form matrix polymers between the reactive materials, employed may be appropriately selected well-known polymerization reactions, as long as it does not xxxxx from the object of this invention. These polymerization reactions include epoxy - amine step polymerization, epoxy - mercaptan step polymerization, unsaturated ester - amine step polymerization (based on Michel addition), unsaturated ester - mercaptan step polymerization (based on Michel addition), vinyl-silicone hydride step polymerization (being hydrosilanization), isocyanate - hydroxyl step polymerization (being a urethane formation), and isocyanate - amine step polymerization (being a urea formation).

The above reaction is enabled or accelerated by use of an appropriate catalysis. For example, an epoxy - mercaptan reaction and a Michel addition are accelerated by a base such as an amine, hydrosilanization is accelerated

in the presence of a transition metal catalyst such as platinum, and urethane formation and urea formation are accelerated when a tin catalyst is employed. In cases when measures, to prevent polymerization of a photoactive monomer, can be taken during light emission, it is also possible to employ a light emission catalyst for matrix formation.

Further, binder-matrix formation by use of a precursor substance consisting of an inorganic material or an inorganic-organic complex material, can be completed, for example, by appropriate selection of well-known mechanisms of alkoxide sol-gel chemistry.

Of these, specifically, in this invention, the matrix forming precursor substance is preferably a compound represented by foregoing Formula (I) or its derivative, but it is more preferably that in Formula (I), a metallic atom represented by M and having a valence of three or more is silicon, titanium, germanium, zirconium, vanadium, or aluminum.

In this invention, at least a portion of the matrix forming precursor substance must be trifunctional (when n = 1) to form a three dimensional matrix structure. It is also effective to employ an oligomer precursor substance, especially a siloxane oligomer.

Matrix formation occurs according to the well-known mechanism of alkoxide sol-gel chemistry. For example, referred to can be C. J. Brinker, et al., "Sol-Gel Science; Physics & Chemistry of Sol-Gel Processing", published by Academic Press, 1990. According to standard alkoxide sol-gel chemistry, curing of a trifunctional oligomer precursor substance starts further condensation, by which the precursor substance forms a three dimensional network. The organic part attached to the base of the final cured matrix, affects the characteristics of the medium, such as flexibility, impact resistance, thermal shock resistance, fraction index, mass density, and abrasion resistance. To provide desirable characteristics, it is effective to use a combination of organic parts, such as both a methyl group and a phenyl group. For example, the methyl group enhances compatibility of a hybrid matrix precursor substance in an optical image forming system, and can mildly initiate a curing state. Further, a phenyl group may reduce curing rate, but it compensates by being superior in compatibility. Due to the large size of phenyl, the phenyl group increases the free volume, and decreases the network density of a matrix, compared to the matrix having only methyl portions. The low network density accelerates diffusion of photoactive the organic monomers during data writing, and provides flexibility to the matrix. In cases when the matrix forming precursor substance is induced by hydrolysis and condensation of the trifunctional organic alkoxy silane, diffusion is also enhanced by incorporation of a dimethylsilyl group into the base of the matrix. This also enhances thermal shock resistance, but reduces the condensation rate of the matrix.

The organic portions removed due to the condensation reaction, affect the matrix forming rate. For example, according to well-known tendency that reaction time of a larger alkoxy group is low, the precursor substance incorporated with a methoxy group reacts sooner than the precursor substance incorporating with an ethoxy group, which is larger than a methoxy group.

In the present invention, the matrix forming precursor substance is procured prior to mixing with the optical image forming system, namely, in the case of the oligomer matrix precursor substance, further condensation is carried out. In cases when procuring is conducted to accelerate the condensation of the matrix forming precursor substance, a milder final curing of the blend of the matrix forming precursor substance/the optical image forming system, is generally required, and the reason is that the final curing is substantially conducted to the condensed oligomer. The reason why the milder curing is advantageous is that damage to the optical image forming system, such as heat-induced procuring of the photoactive monomer, is generally reduced. Precuring is conducted to the degree of enabling substantial diffusion of the procured precursor in the optical image forming system. However, the procuring conditions vary according to the specified highbrid matrix forming precursor substance. Further, it is possible to add, after processing, an organic solvent such as acetone, to dilute the precursor substance. Typically, precuring is conducted at a temperature range of 100 - 200 °C for less than one hour.

Specific compounds of the matrix forming precursor substances include triethoxysilane, an organic siloxane oligomer derived from its hydrolysis and condensation, methyltriethoxysilane, phenyltriethoxysilane, as well as a mixture of methyltriethoxysilane and phenyltriethoxysilane, in addition to dimethyldialkoxysilane, methylphenyldialkoxysilane, and diphenyldialkoxysilane. Further, to provide desired physical properties, several difunctional organic alkoxysilanes may be incorporated.

Before the matrix forming precursor substance (in spite of being procured or not) and the optical image forming system are mixed, the viscosity of the precursor substance is adjusted to less than about 1,000mPa·s, typically by addition of a solvent, to accelerate mixting. By application of heat or use of a solvent, the viscosity of the mixture can be adjusted. Suitable solvents of this invention include alkanols incorporating up to 4 carbon atoms and ketones featuring up to 4 carbon atoms. Alkanol's and ketones can be vaporized from the mixture of the matrix precursor substance/the optical image forming system at a temperature of less than about 80 °C. Acetone is specifically useful for various materials of matrix forming precursor substances, especially for the materials of precursor substances having a siloxane base. When using a solvent, the solvent is typically first mixed with the matrix forming precursor substance, to reduce the viscosity of the precursor substance, and subsequently the optical image forming system is mixed with the solvated precursor substance. The solvent is specifically useful when the matrix precursor substance is procured, because

procuring raises the viscosity of the matrix forming precursor substance. During mixing, the matrix forming precursor substance and the optical image forming system effectively form a solution of the optical image forming system in the solvated matrix forming precursor substance. The solvent is removed by graduated heating under vacuum, by which matrix condensation is further accelerated. This process is terminated as the desired mass is obtained.

Next, described will be the optical image recording material which is applied between the first substrate and the second substrate and consists of laminated optical image recording layers, which contain an oxetane compound having 1 - 4 oxetane rings, a cationic photopolymerization initiator, and a binder-matrix forming precursor substance. Further, since the oxetane compound having 1 - 4 oxetane rings, the cationic photopolymerization initiator and the binder-matrix forming precursor substance, all described here, are the same as the ones described above. Therefore, the first substrate and the second substrate will now be described in detail.

As the first substrate and the second substrate constituting the optical image recording material, any appropriate material may be employed without limitation, as long as it is transparent and does not cause expansion or contraction, and bending at the temperature in the used environment, and further it does not react with the foregoing composition for recording. Examples of these substrates include glass such as quartz glass, soda glass, potash glass, lead crystal glass, borosilicate glass, aluminosilicate glass, titanium crystal glass or crystallized glass; and various resins, for example, polyimide such as polycarbonate, polyacetal, polyallylate, poly(etheretherketone), polysulfone and poly(ethersulfone), polyimide-amide or polyetherimide; polyamide; polyolefine such as cyclo-olefine ring-opening polymer, and any of which may be employed.

On the other hand, in an optical image recording material, by making an optical image recording layer as thick as possible, produced may be the optical image recording material of high storage capacity. However, in cases when considering usage of the optical image recording material and reading error of recorded data, it is desired that deformation of the optical image recording material is as low as possible. Therefore, in this invention, by adjusting the thickness of the first substrate $D_1$) and of the second substrate ($D_2$) to satisfy the following relationship: $0.5 \leq D_1/D_2 \leq 2.0$, it is possible to prevent deformation of the optical image recording material during production, as well as before and after holography recording via irradiation of active rays, described later.

Active rays include ultraviolet rays, visible rays, X-rays and electron beams. Various light sources may be employed as a light source to cure the optical material, such as UV rays or visible rays, for example, listed are a pressured or high-pressure mercury vapor lamp, a metal halide lamp, a xenon lamp, an electrodeless discharge lamp, a carbon arc lamp, a laser or an LED. When cured by electron beams, various irradiation devices may be employed, for example, listed are the Cockcroft-Walton type, the Van de Graaff type and a resonance transformer type, and electron beams preferably of 50 - 1,000 eV energy, but more preferably 100 - 300 eV. In this invention, preferably employ, for example, is a GaN UV ray laser (of 400 - 415 nm), an $Ar^-$ (of 458, 488 and 514 nm) and an He-Cd laser (of 442 nm), a frequency duplex YAG laser (of at 532 nm), an He-Ne laser (of at 633 nm), and a $Kr^+$ laser (of at 647 and 676 nm).

Now, a basic configuration of the holographic system of this invention will be described.

Fig. 1 is a schematic diagram showing a basic configuration of a holographic system employable in this invention. Holographic System 10 incorporates Modulating Device 12, Optical Image Recording Material 14, and Sensor 16. As long as Modulating Device 12 is able to optically express data in two dimensions, any kind of device may be employed. Modulating Device 12 is typically a special light modulator assembled in an encoding unit which encodes data on the modulating device. Based on encoding, Modulating Device 12 selectively passes on or interrupts a part of Signal Beam 20 which passes Modulating Device 12. Thus, Signal Beam 20 is coded with data image. An image is memorized by making Signal Beam 20 and Reference Beam 22, which are both coded, interfere, in certain locations of on or inside of Optical Image Recording Material 14. This interference produces an interference pattern (namely, a hologram), and is saved as a pattern of a changing refraction index into Optical Image Recording Material 14. It is possible to also make more than one holography images to be memorized in one location, or to make a plurality of holograms be memorized in an overlapped state by changing the angle, wavelength or phase of Reference Beam 22. Typically, Signal Beam 20 passes through Lens 30 before it intersects Reference Beam 22 in Optical Image Recording Material 14. Reference Beam 22 is able to pass through Lens 32 before this intersection. When the data is memorized in Optical Image Recording Material 14, it is possible to search for the data by intersecting Reference Beam 22 at the same angle, wavelength or phase as during data memory, in the same location of Optical Image Recording Material 14. The reconfigurated data again passes through Lens 34, and is detected by Sensor 16. Sensor 16 is, for example, a charge-coupled device or an active picture element sensor. Sensor 16 is typically integral to the data demodulating unit.

In the present invention, the material which is recorded on the optical image recording material is specifically termed "hologram material".

## EXAMPLES

The present invention will be described with reference to examples, however, the embodiments of this invention are not limited by these examples.

Preparation of Optical Image Recording Material

Preparation of Optical Image Recording Material: This Invention

Each of the following components of an optical image recording material and a matrix forming precursor substance were blended, and after being uniformly dissolved, Composition Solution 1 was prepared by blending of the dissolved optical image recording material and the dissolved matrix forming precursor substance. Subsequently, Composition Solution 1 was poured onto a 0.8 mm glass slide which was surrounded on all four side by a Teflon® spacer having a thickness of about 500 μm, and a diameter of 25 mm, on which another 0.8 mm thick glass slide was then placed on it, and stored at room temperature for about 24 hours to cure the matrix forming precursor substance, whereby Optical Image Recording Material 1 was prepared.

Composition Solution 1

Optical Image Recording Material

| | |
|---|---|
| Oxetane compound (Exemplified Compound 5) | 18 weight% |
| Initiator: Irgacure 784 (*1 produced by Ciba·Specialty·Chemicals) | 0.2 weight% |
| Sensitizing agent: pyrazolotriazole dye I | 0.02 weight% |

*1) Irgacure 784: bis($n^5$-2,4-cyclopentadiene-1-yl)bis[2,6-difluoro-3-(1H-pyrol-1-yl)phenyl]titanium

Matrix Forming Precursor Substance

| | |
|---|---|
| Monomer 1: Diisocyanate terminal polypropylene Glycol, at a molecular weight of 2471) | 68.6 weight% |
| Monomer 2: α,ω-dihydroxypolypropylene glycol (at a molecular weight of 425) | 13.08 weight% |
| Catalyst: Dibutyltin dilaurate | 0.1 weight% |

Pyrazolotriazole dye 1

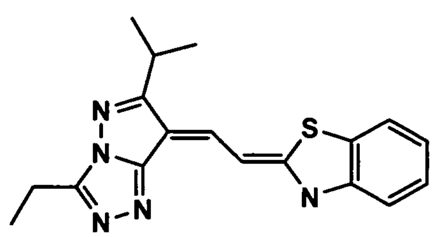

Preparation of Optical Image Recording Material 2: This Invention

Optical Image Recording Material 2 was prepared in the same manner as foregoing Optical Image Recording Material 1, except that Composition Solution 2 consisted of the following components was employed.

Composition Solution 2

Optical Image Recording Material

| | |
|---|---|
| Oxetane compound (exemplified compound 4) | 13 weight% |
| Epoxy compound (exemplified compound E-1) | 5 weight% |
| Initiator: Irgacure 784 (produced by Ciba·Specialty·Chemicals) | 0.2 weight% |
| Sensitizing agent: Pyrazolotriazole dye 1 | 0.02 weight% |

Matrix Forming Precursor Substance

| | |
|---|---|
| Monomer 1: Polypropylene glycol digrycidyl ether (at a molecular weight of 380) | 47.5 weight% |
| Monomer 2: Pentaerithritoltetrakis(mercaptopropyonate) | 30.7 weight% |
| Catalyst: tris(2,4,6-dimethylaminomethyl)phenol | 3.58 weight% |

Preparation of Optical Image Recording Material 3: This Invention

Optical Image Recording Material 3 was prepared in the same manner as foregoing Optical Image Recording Material 1, except that Composition Solution 3 consisting of the following components was employed.

Composition Solution 3

Optical Image Recording Material

| | |
|---|---|
| Oxetane compound (exemplified compound 7) | 13 weight% |
| Vinyl ether compound [$CH_2$=CH-O-($CH_2CH_2O$)$_3$-CH=$CH_2$] | 5 weight% |
| Initiator: Irgacure 784 (produced by Ciba·Specialty·Chemicals) | 0.2 weight% |
| Sensitizing agent: Pyrazolotriazole dye 1 | 0.02 weight% |

Matrix Forming Precursor Substance

| | |
|---|---|
| Monomer 1: Polypropylene glycol digrycidyl ether (having a molecular weight of 380) | 47.5 weight% |
| Monomer 2: Pentaerithritoltetrakis(mercaptopropyonate) | 30.7 weight% |
| Catalyst: tris(2,4,6-dimethylaminomethyl)phenol | 3.58 weight% |

Preparation of Optical Image Recording Material 4: This Invention

Optical Image Recording Material 4 was prepared in the same manner as foregoing Optical Image Recording Material 1, except that Composition Solution 4 consisting of the following components was employed.

Composition Solution 4

Optical Image Recording Material

| | |
|---|---|
| Oxetane compound (exemplified compound 3) | 13 weight% |

(continued)

| | |
|---|---|
| (Metha)crylate compound (lauryl acrylate) | 5 weight% |
| Initiator: Irgacure 784 (produced by Ciba·Specialty·Chemicals) | 0.2 weight% |
| Sensitizing agent: Pyrazolotriazole dye 1 | 0.02 weight% |

Matrix Forming Precursor Substance

| | |
|---|---|
| Monomer 1: Polypropylene glycol digrycidyl ether (at a molecular weight of 380) | 47.5 weight% |
| Monomer 2: Pentaerithritoltetrakis(mercaptopropyonate) | 30.7 weight% |
| Catalyst: tris(2,4,6-dimethylaminomethyl)phenol | 3.58 weight% |

Preparation of Optical Image Recording Material 5: This Invention

Optical Image Recording Material 5 was prepared in the same manner as foregoing Optical Image Recording Material 1, except that Composition Solution 5 consisted of the following components was employed.

Composition Solution 5

Optical Image Recording Material

| | |
|---|---|
| Oxetane compound (exemplified compound 3) | 13 weight% |
| 4-bromostylene | 5 weight% |
| Initiator: Irgacure 784 (produced by Ciba·Specialty·Chemicals) | 0.2 weight% |
| Initiator: Irgacure 369 (*2 produced by Ciba·Specialty·Chemicals) | 0.1 weight% |
| Sensitizing agent: Pyrazolotriazole dye 1 | 0.02 weight% |
| *2) Irgacure 369: 2-benzyl-2-dimethylamino-1-(4-morphorinophenyl)-butanone-1 | |

Matrix Forming Precursor Substance

| | |
|---|---|
| Monomer 1: Polypropylene glycol digrycidyl ether (at a molecular weight of 380) | 47.5 weight% |
| Monomer 2: Pentaerithritoltetrakis (mercaptopropyonate) | 30.7 weight% |
| Catalyst: tris(2,4,6-dimethylaminomethyl)phenol | 3.58 weight% |

Preparation of Optical Image Recording Material 5:

Comparative Example

Optical Image Recording Material 6 was prepared in the same manner as foregoing Optical Image Recording Material 1, except that Composition Solution 6 consisting of the following components was employed.

Composition Solution 6

Optical Image Recording Material

| | |
|---|---|
| Epoxy compound (exemplified compound E-1) | 18 weight% |

(continued)

| | |
|---|---|
| Initiator: Irgacure 784 (produced by Ciba·Specialty·Chemicals)<br>Sensitizing agent: Pyrazolotriazole dye 1 | 0.2 weight%<br>0.02 weight% |

Matrix

| | |
|---|---|
| Poly(methylphenylsiloxane) (being Dow 710 Silicone Liquid, produced by The Dow Chemical Company) | 81.75 weight% |

Preparation of Optical Image Recording Material 7:

Comparative Example

Optical Image Recording Material 7 was prepared in the same manner as foregoing Optical Image Recording Material 1, except that Composition Solution 7 consisting of the following components was employed.

Composition Solution 7

Optical Image Recording Material

| | |
|---|---|
| (Metha)crylate compound (lauryl acrylate)<br>Initiator: Irgacure 784 (produced by Ciba·Specialty·Chemicals)<br>Sensitizing agent: Pyrazolotriazole dye 1 | 18 weight%<br>0.2 weight%<br>0.02 weight% |

Matrix Forming Precursor Substance

| | |
|---|---|
| Monomer 1: Diisocyanate terminal polypropylene glycol (having a molecular weight of 2471)<br>Monomer 2: $\alpha,\omega$-dihydroxypolypropylene glycol (having a molecular weight of 425)<br>Catalyst: Dibutyltin dilaurate | 68.6 weight%<br>13.08 weight%<br>0.1 weight% |

Preparation of Optical Image Recording Material 8:

Comparative Example

Optical Image Recording Material 8 was prepared in the same manner as foregoing Optical Image Recording Material 1, except that Composition Solution 8 consisting of the following components was employed.

Composition Solution 8

Optical Image Recording Material

| | |
|---|---|
| 4-bromostylene<br>Initiator: Irgacure 784 (produced by Ciba·Specialty·Chemicals)<br>Sensitizing agent: Pyrazolotriazole dye 1 | 18 weight%<br>0.2 weight%<br>0.02 weight% |

Matrix Forming Precursor Substance

| | |
|---|---|
| Monomer 1: Polypropylene glycol digrycidyl ether (having a molecular weight of 380) | 47.5 weight% |
| Monomer 2: Pentaerithritoltetrakis (mercaptopropyonate) | 30.7 weight% |
| Catalyst: tris(2,4,6-dimethylaminomethyl) Phenol | 3.58 weight% |

Preparation of Optical Image Recording Material 9: This Invention

Optical Image Recording Material 9 was prepared in the same manner as foregoing Optical Image Recording Material 1, except that Composition Solution 9 consisting of the following components was employed.

Composition Solution 9

Optical Image Recording Material

| | |
|---|---|
| Oxetane compound (exemplified compound 3) | 13 weight% |
| 4-bromostylene | 5 weight% |
| Initiator: Irgacure 784 (produced by Ciba·Specialty·Chemicals) | 0.2 weight% |
| Initiator: Irgacure 369 (produced by Ciba·Specialty·Chemicals) | 0.1 weight% |
| Sensitizing agent: Pyrazolotriazole dye 1 | 0.02 weight% |

Matrix Forming Precursor Substance

| | |
|---|---|
| Methiphenyl(didodecyloxy)silane | 25.5 weight% |
| Distilled water | 0.84 weight% |

Image Forming and Evaluation of Optical Image Recording Materials

Onto Optical Image Recording Materials 1 - 9, prepared as above, a series of multiplex holograms was written based on the procedures described in U.S. Patent No. 5,719,691, after which measurement and evaluation were conducted regarding sensitivity (being recording energy), shrinkage resistance and contrast of the refraction index, based on the following methods, obtained results of which are shown in Table 1.

Measurement of Sensitivity

Onto each of the prepared optical image recording materials for holograms, the digital patterned hologram, which was displayed using a hologram forming device with an Nd-YAG laser (532 nm), shown in Fig. 1, was exposed with an energy of 0.5 - 20 $mJ/cm^2$, to obtain a hologram. Using an Nd-YAG laser (532 nm) an a reference light, the generated regeneratrd light was read with CCD, and the minimum exposure value by which a good digital pattern was obtained, was designated as sensitivity.

Evaluation of Shrinkage Resistance

Shrinkage Resistance is shown as the shrinkage ratio which is measured based on the following method. Fig. 2 is a schematic diagram showing principles of measuring equipment used for determining the shrinkage ratio. Namely, the light emitting point of a white illumination light source which illuminates Hologram 3 is set at 01, while the eye position of the observer is represented by 02. In the measuring equipment, White Illumination Light Source 4 is installed at Light emitting Point 01, and Spectroscope 5 is installed at Eye Position 02. Spectroscope 5 is connected to Personal Computer 6, and Movable Pinhole Plate 7, provided with Pinhole 8 which only pases some of light, is installed on the upper surface of Hologram 3 which determines the luminance distribution of the specific spectral wavelengths. Movable

Pinhole Plate 7 is attached to an XY stage (not shown) and is structured to be movable in any desired direction.

Namely, when Movable Pinhole Plate 7 is positioned at Point P (I, J), and the angle to the line from the center of Pinhole 8 to White Illumination Light Source 4 is represented by θc, and to Spectroscope 5 is represented by θi. The region of Point P (I, J) of Hologram 3 is subjected to illumination from the θc angle employing Illumination Light 9, and Regenerated light 11 is emitted in θI direction. Regenerated light 11 is subjected to spectrometry employing Spectroscope 5, whereby a wavelength resulting in maximum luminance is designated as Regenerated Wavelength λc at P (I, J). By employing this relationship, θc, θi and λc at each point of Hologram 3 are determined while moving Movable pinhole plate 7.

Further, assuming that the shrinkage ratio of the hologram at Point P (I, J) to be M (I, J), the shrinkage ratio of the hologram, M (I, J), can be expressed by the following formula, setting an average refraction index of the optical image recording material before recording to be nr, and the average refraction index of the hologram after photographic processing to be nc.

$$M(I, J) = -nc/nr \cdot \lambda r/\lambda c \cdot (\cos\theta c - \cos\theta i)/(\cos\theta o - \cos\theta r)$$

In the above formula, θo is incidence angle to the optical image recording material, λr is wavelength of the laser beam, and θr is incidence angle of the reference light to the optical image recording material.

Evaluation of Contrast of Refraction Index

Contrast of the refraction index is determined as the diffraction efficiency measured by the following method. Measurement of the diffraction efficiency is conducted by using the ART25C spectrophotometer, manufactured by Jasco Corp., and a photomultimeter featuring a 3 mm wide slit provided on the circumference of a 25 cm diameter centered a sample. A 0.3 mm monochromatic light beam is incidented to the sample at an angle of 45 degree, and the diffracted light from the sample is detected. The ratio of the largest value of other than specular reflection light, to the value when directly acceptive the incident light without placing the sample, is defined as a diffraction efficiency, and contrast of the refraction index (being Δν) was determined from the obtained diffraction efficiency of the hologram.

Table 1

| Optical image recording material No. | Sensitivity (Recording energy) ($mJ/cm^2$) | Shrinkage ratio (%) | Contrast of refraction index ($\Delta n \times 10^{-3}$) | Remarks |
|---|---|---|---|---|
| 1 | 1.5 | 0.2 | 7.5 | Inv. |
| 2 | 2.0 | 0.2 | 7.7 | Inv. |
| 3 | 1.5 | 0.3 | 7.0 | Inv. |
| 4 | 2.0 | 0.2 | 7.5 | Inv. |
| 5 | 2.0 | 0.2 | 7.0 | Inv. |
| 6 | 20 | 0.3 | 2.5 | Comp. |
| 7 | 15 | 3.0 | 2.5 | Comp. |
| 8 | 20 | 3.5 | 1.7 | Comp. |
| 9 | 3.5 | 0.2 | 5.5 | Inv. |
| Note: Inv.: This invention Comp.: Comparative example | | | | |

As is apparent from Table 1, it is proven that an optical image recording material of the present invention containing an oxetane compound of 1 - 4 oxetane rings, and a cationic photopolymerization initiator exhibits superior superiority, lowered shrinkage ratio, and superior contrast of refraction index, compared to the comparative examples.

Industrial Applicability

Based on the present invention, it is possible to provide an optical image recording material which is superior in sensitivity, shrinkage resistance and contrast, and to provide a recording method and a production method using the same.

## Claims

1. An optical image recording material comprising an oxetane compound containing one to four oxetane rings in the molecule, a cationic photopolymerization initiator and a matrix forming precursor substance.

2. The optical image recording material of Claim 1, further comprising a compound containing an epoxy group in the molecule.

3. The optical image recording material of Claim 1, further comprising a compound containing a vinyl ether group in the molecule.

4. The optical image recording material of Claim 1, further comprising:

   (i) a compound containing an acryloyl group or
   (ii) a metacryloyl group in the molecule; and
   (iii) a photo radical polymerization initiator.

5. The optical image recording material of Claim 1, wherein the matrix forming precursor substance is capable of forming a binder-matrix with at least one polymerization reaction selected from the group consisting of epoxy - amine step polymerization, epoxy - mercaptan step polymerization, unsaturated ester - amine step polymerization, unsaturated ester - mercaptan step polymerization, vinyl-silicone hydride step polymerization, isocyanate - hydroxyl step polymerization, and isocyanate - amine step polymerization.

6. The optical image recording material of Claim 1, wherein the matrix forming precursor substance is represented by Formula (I):

   Formula (I)

   $$R_nM(OR')_{4-n}$$

   wherein M is a metallic atom having an atomic valence of not less than trivalent, R is an alkyl or allyl group, R' is a lower alkyl group having carbon atoms of not more than four, and "n" is 1 or 2.

7. The optical image recording material of Claim 6, wherein M in Formula (I) is a metallic atom selected from the group consisting of silicon, titanium, germanium, zirconium, vanadium, and aluminum.

8. An optical image recording material comprising a first substrate, a second substrate, and an optical image recording layer between the first and the second substrate,
   wherein the optical image recording layer contains an oxetane compound having one to four oxetane rings, a cationic photopolymerization initiator, and a matrix forming precursor substance.

9. The optical image recording material of Claim 8, wherein a thickness of the first substrate ($D_1$) and the second substrate ($D_2$) satisfies the following relationship:

   $$0.5 \le D_1/D_2 \le 2.0$$

10. The optical image recording material of Claim 8 containing a binder-matrix obtained by curing a portion of the matrix forming precursor substance.

11. A hologram material obtained by applying holography recording irradiated with active rays onto the optical image recording material of Claim 10.

12. An optical image recording material comprising a first substrate, a second substrate, and an optical image recording layer between the first and the second substrate,
    wherein the optical image recording layer contains an oxetane compound having one to four oxetane rings in the molecule, a cationic photopolymerization initiator, and a binder-matrix.

**13.** A hologram material comprising a first substrate, a second substrate, and an optical image recording layer between the first and the second substrate,

wherein the hologram material contains:

(i) a binder-matrix; and
(ii) a polymer obtained by irradiating with active rays to an oxetane compound having one to four oxetane rings in the molecule.

**14.** An optical image recording method using the optical image recording material described in Claim 8 comprising the steps of:

a) forming a binder-matrix by curing a portion of the matrix forming precursor substance; and
b) conducting hologram recording by irradiating with active rays onto the optical image recording material.

**15.** The production method of the optical image recording material described in Claim 12, comprising the steps of:

a) mixing an oxetane compound containing one to four oxetane rings in the molecule, a matrix forming precursor substance, and a cationic photopolymerization initiator; and
b) forming a binder-matrix by curing a portion of matrix forming precursor substance.

**16.** The production method the hologram material described in Claim 13, comprising the steps of:

a) mixing an oxetane compound containing one to four oxetane rings in the molecule, a matrix forming precursor substance, and a cationic photpolymerization initiator;
b) forming a binder-matrix by curing a portion of matrix forming precursor substance; and
c) conducting hologram recording by irradiating with active rays onto the optical image recording material.

FIG. 1

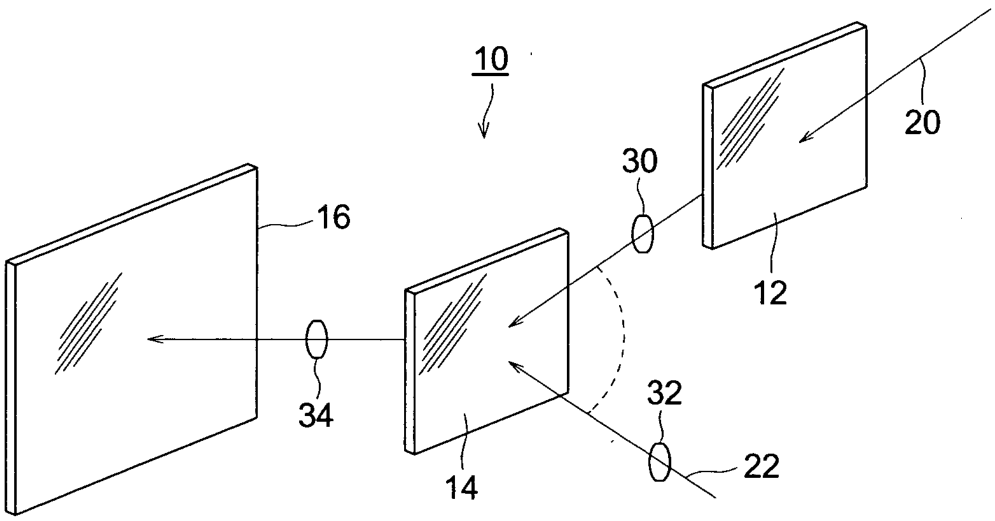


FIG. 2

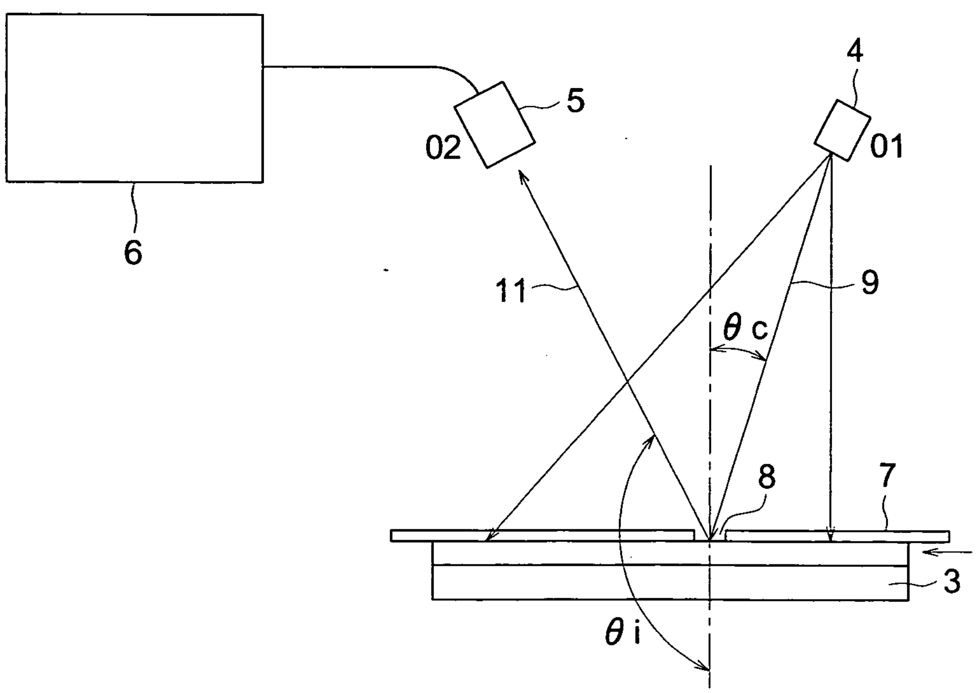

# INTERNATIONAL SEARCH REPORT

International application No.
PCT/JP03/08634

A. CLASSIFICATION OF SUBJECT MATTER
Int.Cl[7] G03F7/004, G03H1/02, C08G65/18

According to International Patent Classification (IPC) or to both national classification and IPC

B. FIELDS SEARCHED

Minimum documentation searched (classification system followed by classification symbols)
Int.Cl[7] G03F7/00-7/42, G03H1/02, C08G65/18

Documentation searched other than minimum documentation to the extent that such documents are included in the fields searched

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | EP 848294 A1 (JAPAN SYNTHETIC RUBBER CO., LTD.), 17 June, 1998 (17.06.98), Full text; all drawings & JP 10-168165 A & US 5981616 A1 | 1-4<br>5-7 |
| X<br>Y | JP 2000-221870 A (Daiwa Can Co.), 11 August, 2000 (11.08.00), Par. Nos. [0021] to [0026] (Family: none) | 1-4<br>5-7 |
| X<br>Y | JP 2002-62411 A (Toppan Printing Co., Ltd.), 28 February, 2002 (28.02.02), Full text; all drawings (Family: none) | 1-4<br>5-7 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07 October, 2003 (07.10.03) | 21 October, 2003 (21.10.03) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP03/08634

C (Continuation). DOCUMENTS CONSIDERED TO BE RELEVANT

| Category* | Citation of document, with indication, where appropriate, of the relevant passages | Relevant to claim No. |
|---|---|---|
| Y | JP 8-262700 A (KRI International, Inc.), 11 October, 1996 (11.10.96), Full text; all drawings (Family: none) | 1-7 |
| Y | US 2002/0004172 A1 (NIPPON SHEET GLASS CO., LTD.), 10 January, 2002 (10.01.02), Full text; all drawings & JP 6-19040 A | 1-7 |
| Y | EP 980025 A1 (AGENCY OF INDUSTRIAL SCIENCE AND TECHNOLOGY), 16 February, 2000 (16.02.00), Full text & JP 2001-109360 A | 1-7 |
| P,X | JP 2002-236440 A (Dainippon Printing Co., Ltd.), 23 August, 2002 (23.08.02), Claims; Par. Nos. [0039] to [0050] (Family: none) | 1-7 |

Form PCT/ISA/210 (continuation of second sheet) (July 1998)

**INTERNATIONAL SEARCH REPORT**

International application No.
PCT/JP03/08634

**Box I Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box II Observations where unity of invention is lacking (Continuation of item 3 of first sheet)**

This International Searching Authority found multiple inventions in this international application, as follows:

1. Claims 1-7 are directed to inventions having the same technical feature in comprising an oxetane compound having 1 to 4 oxetane rings, a photocationic polymerization initiator and a matrix forming precursor. 2. Claims 8-11 and 14 are directed to inventions having the same technical feature in having an optical image recording layer comprising an oxetane compound having 1 to 4 oxetane rings, a photocationic polymerization initiator and a matrix forming precursor. 3. Claims 12 and 15 are directed to inventions having the same technical feature in having an optical image recording layer comprising an oxetane compound having 1 to 4 oxetane rings, a photocationic polymerization (continued to extra sheet)

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.: 1-7.

**Remark on Protest** ☐ The additional search fees were accompanied by the applicant's protest.

☐ No protest accompanied the payment of additional search fees.

Form PCT/ISA/210 (continuation of first sheet (1)) (July 1998)